# EUROPEAN PATENT APPLICATION

(11) **EP 4 766 125 A1**
(43) Date of publication of application: **24.06.2026**
(21) Application number: 23949150.9
(22) Date of filing: 15.08.2023
(51) Int. Cl.: H10N 60/12

(54) **QUANTUM DEVICE**

(71) Applicant: FUJITSU LIMITED, Kawasaki-shi, Kanagawa 211-8588 (JP)
(72) Inventor: SAIDA, Daisuke, Kawasaki-shi, Kanagawa 211-8588 (JP)
(74) Representative: Haseltine Lake Kempner LLP
(86) International application number: PCT/JP2023/029514
(87) International publication number: WO 2025/037380

(57) **Abstract**

A quantum device includes one or more qubits. Each of the one or more qubits includes a first conductor, a second conductor, and a Josephson junction element connected between the first conductor and the second conductor, and a capacitance of each of the one or more qubits with respect to ground potential is 10 fF or more and 30 fF or less. The quantum device can be used in, for example, quantum computing.

## Description

### TECHNICAL FIELD

The present disclosure relates to a quantum device.

### BACKGROUND ART

As one type of quantum bit (qubit) used in a quantum computer, a qubit including a Josephson junction element is known.

### RELATED-ART DOCUMENTS

### PATENT DOCUMENTS

Patent Document 1: Japanese Laid-open Patent Publication No. 2020-61447
Patent Document 2: Japanese National Publication of International Patent Application No. 2021-516389
Patent Document 3: U.S. Patent Application Publication No. 2014/0246652
Patent Document 4: Japanese National Publication of International Patent Application No. 2018-512729

### SUMMARY OF THE INVENTION

### PROBLEM TO BE SOLVED BY THE INVENTION

It is desirable that a qubit efficiently responds to an input signal for manipulating the state of the qubit. The efficient response of the qubit can be achieved by providing a quantum device that can obtain a large internal current with respect to the signal input into the qubit.

It is an object of the present disclosure to provide a quantum device that can increase an internal current of a qubit obtained with respect to an input signal.

### MEANS TO SOLVE THE PROBLEM

According to one aspect of the present disclosure, a quantum device includes one or more qubits, wherein each of the one or more qubits includes a first conductor, a second conductor, and a Josephson junction element connected between the first conductor and the second conductor, and a capacitance of each of the one or more qubits with respect to ground potential is 10 fF or more and 30 fF or less.

### EFFECTS OF THE INVENTION

According to the present disclosure, an internal current of a qubit obtained with respect to an input signal can be increased.

### BRIEF DESCRIPTION OF THE DRAWINGS

[FIG. 1] FIG. 1 is a circuit diagram illustrating a model used for simulation;
[FIG. 2] FIG. 2 is a graph illustrating the relationship between a capacitance of a capacitor and an internal current;
[FIG. 3] FIG. 3 is a diagram illustrating a preferred range of a ratio R between capacitances of two capacitors with respect to a resonance frequency fr;
[FIG. 4] FIG. 4 is a diagram illustrating a preferred range of the ratio R with respect to a critical current Ic of a Josephson junction element;
[FIG. 5] FIG. 5 is a schematic diagram illustrating a quantum device according to a first embodiment;
[FIG. 6] FIG. 6 is a schematic diagram illustrating a quantum device according to a second embodiment;
[FIG. 7] FIG. 7 is a schematic diagram illustrating a quantum device according to a third embodiment;
[FIG. 8] FIG. 8 is a schematic diagram illustrating a quantum device according to a fourth embodiment;
[FIG. 9] FIG. 9 is a schematic diagram illustrating extension portions of a quantum device according to a fifth embodiment;
[FIG. 10] FIG. 10 is a schematic diagram illustrating extension portions of a quantum device according to a sixth embodiment;
[FIG. 11] FIG. 11 is a cross-sectional view (part 1) illustrating examples of the cross-sectional shapes of the extension portions and a relay conductor;
[FIG. 12] FIG. 12 is a cross-sectional view (part 2) illustrating examples of the cross-sectional shapes of the extension portions and the relay conductor;
[FIG. 13] FIG. 13 is a schematic diagram illustrating a quantum device according to a seventh embodiment;
[FIG. 14] FIG. 14 is a schematic diagram illustrating a quantum device according to an eighth embodiment;
[FIG. 15] FIG. 15 is a schematic diagram illustrating a quantum device according to a ninth embodiment;
[FIG. 16] FIG. 16 is a schematic diagram illustrating a quantum device according to a tenth embodiment;
[FIG. 17] FIG. 17 is a schematic diagram illustrating a quantum device according to an eleventh embodiment;
[FIG. 18] FIG. 18 is a schematic diagram illustrating a quantum device according to a twelfth embodiment; and
[FIG. 19] FIG. 19 is a schematic diagram illustrating a quantum device according to a thirteenth embodiment.

### MODE FOR CARRYING OUT THE INVENTION

Embodiments of the present disclosure will be described in detail below with reference to the accompanying drawings. In the specification and the drawings, components having substantially the same functional configurations are denoted by the same reference numerals, and redundant descriptions thereof may be omitted.

### (Basic Principle of Present Disclosure)

First, the basic principle of the present disclosure will be described. It is known that a Josephson junction element behaves as a nonlinear inductor. Therefore, the present inventor considered modeling of a qubit including a Josephson junction element such that the qubit can be implemented in a superconducting circuit simulator while the Josephson junction element is regarded as a nonlinear inductor. In this modeling, the behavior of the qubit when a signal having a resonance frequency is externally applied to the qubit during a gate operation or the like was studied. At this time, as the signal having the resonance frequency, a signal that causes a perturbation while the qubit remains in a ground state rather than causing the qubit to transition to an excited state was assumed. By using such a signal, a model can be obtained in which an internal current having a resonance frequency and a time-averaged value of zero flows in the ground state with a magnitude smaller than that of the zero-point fluctuation. For example, when this model is applied to a transmon, which is one type of gate-based qubit, the qubit remains in the ground state, thereby ensuring that conditions for a transmon regime are satisfied in simulation. Further, a change occurring in a qubit and a change occurring in a system coupled to the qubit when a signal having a resonance frequency is given can be observed as an internal current of a circuit by using the superconducting circuit simulator. Thus, it is possible to implement a qubit in the superconducting circuit simulator by including a capacitor and the like in an equivalent circuit of the qubit while regarding a Josephson junction as a nonlinear inductor.

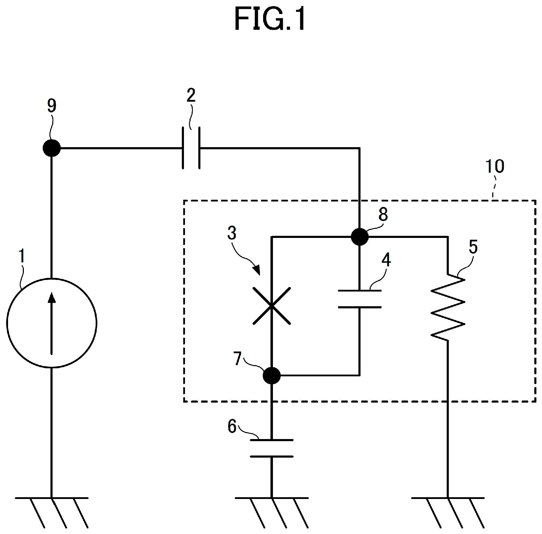

Further, in a quantum device in which two qubits are capacitively coupled to each other, an inductance is present in a line for capacitive coupling. Therefore, the present inventor adopted a model that takes the inductance of this line into account and assumes that a resistance is provided between an end portion of the line, which serves as an open end for the capacitive coupling, and ground. For example, in the case of a transmon, a model in which a Josephson junction element, a capacitor, and a resistance element are connected in parallel is adopted. FIG. 1 is a circuit diagram illustrating a model used for simulation.

As illustrated in FIG. 1, this model includes a current source 1, a capacitor 2, a Josephson junction element 3, a capacitor 4, a resistance element 5, and a capacitor 6. A qubit 10 includes the Josephson junction element 3, the capacitor 4, and the resistance element 5. The Josephson junction element 3 and the capacitor 4 are connected in parallel with each other, and the capacitor 6 is connected between a node 7, on one side of the Josephson junction element 3 and of the capacitor 4, and ground. Further, the resistance element 5 is connected between a node 8, on the other side of the Josephson junction element 3 and of the capacitor 4, and ground. The current source 1 is connected between the node 9 and ground, and the capacitor 2 is connected between the node 8 and the node 9. A capacitance C6 of the capacitor 6 corresponds to a capacitance Cg between the qubit 10 and ground.

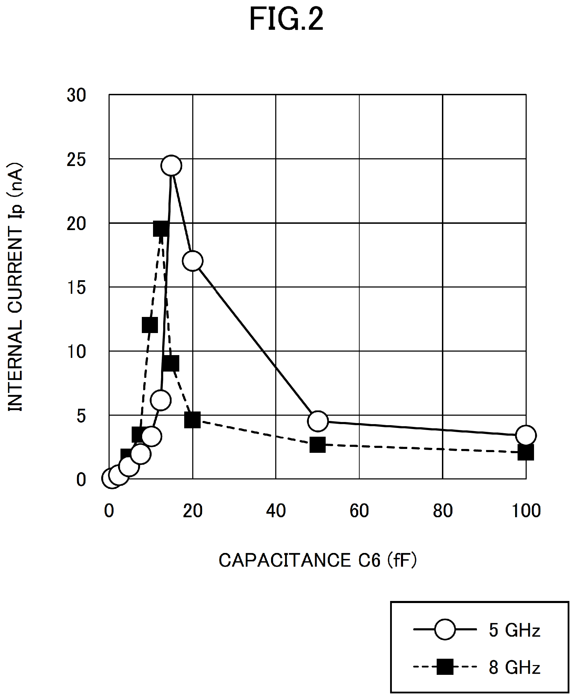

The present inventor conducted simulation using the model illustrated in FIG. 1, and as a result, results illustrated in FIG. 2 were obtained. FIG. 2 is a graph illustrating the relationship between the capacitance C6 of the capacitor 6 and an internal current Ip. In FIG. 2, the horizontal axis indicates the capacitance C6 of the capacitor 6, and the vertical axis indicates the internal current Ip. FIG. 2 illustrates results when a resonance frequency fr was 5 GHz and results when a resonance frequency fr was 8 GHz. In this simulation, the size of the Josephson junction element 3 was kept constant. Therefore, the difference in the resonance frequency fr reflects the difference in the capacitance of the capacitor 4. Although there is a difference in the magnitude of the internal current Ip between the case where the resonance frequency fr is 5 GHz and the case where the resonance frequency fr is 8 GHz, the tendency of changes in the internal current Ip is similar. This indicates that the tendency of changes in the internal current Ip is similar even when the capacitance of the capacitor 4 is different. For example, in both cases, the peak of the internal current Ip appears when the capacitance C6 of the capacitor 6 is 18 fF to 20 fF, and the internal current Ip is high when the capacitance C6 of the capacitor 6 is 10 fF or more and 30 fF or less. The range of 10 fF or more and 30 fF or less generally corresponds to the range of ±3σ when the results illustrated in FIG. 2 are approximated by a normal distribution.

As described above, according to a simulation method newly discovered by the present inventor, it was found that a large internal current Ip is obtained in the qubit 10 when the capacitance between the qubit 10 and ground is 10 fF or more and 30 fF or less. Note that, as confirmed by the present inventor, in a conventional quantum device, the capacitance between a qubit and ground is 100 fF at the smallest.

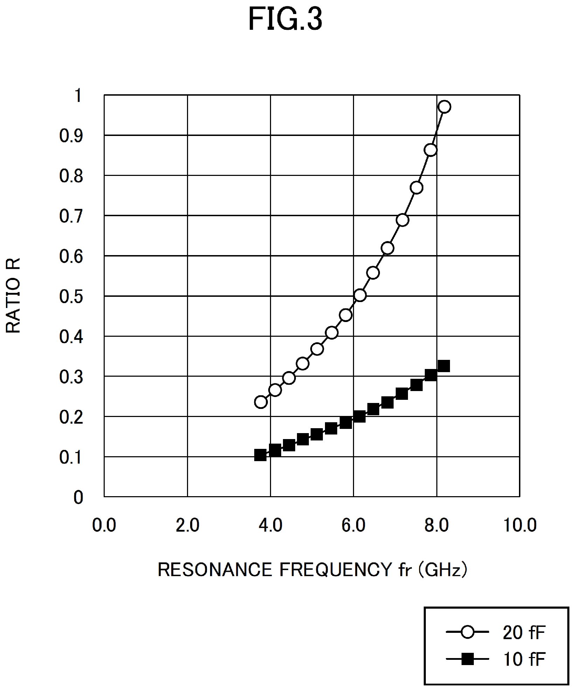

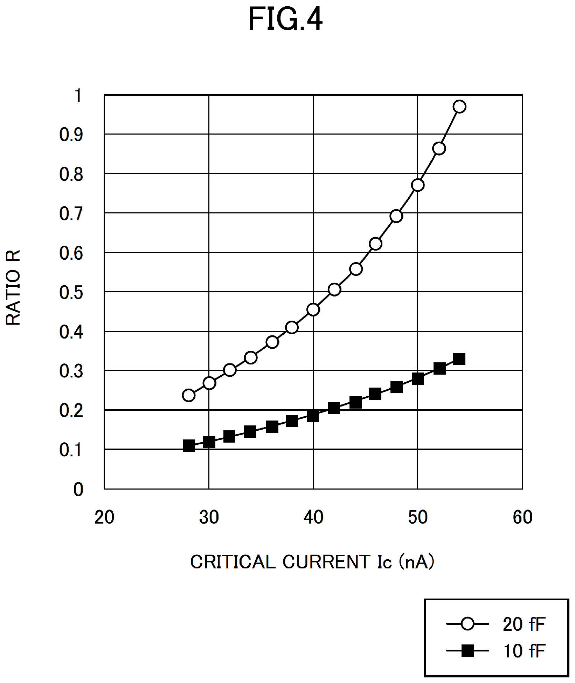

Further, preferred ranges of a ratio R of the capacitance C6 of the capacitor 6 to a capacitance C4 of the capacitor 4 obtained by simulation conducted by the present inventor are as follows. FIG. 3 is a diagram illustrating a preferred range of the ratio R with respect to the resonance frequency fr. FIG. 4 is a diagram illustrating a preferred range of the ratio R with respect to a critical current Ic of the Josephson junction element 3. In FIG. 3, the horizontal axis indicates the resonance frequency fr, and the vertical axis indicates the ratio R. In FIG. 4, the horizontal axis indicates the critical current Ic, and the vertical axis the ratio R. When the capacitance Cg between the qubit 10 and ground is 10 fF or more and 20 fF or less, the ratio R is preferably in the range between two curves in FIG. 3 according to the resonance frequency fr, and the ratio R is preferably in the range between two curves in FIG. 4 according to the critical current Ic.

### (First Embodiment)

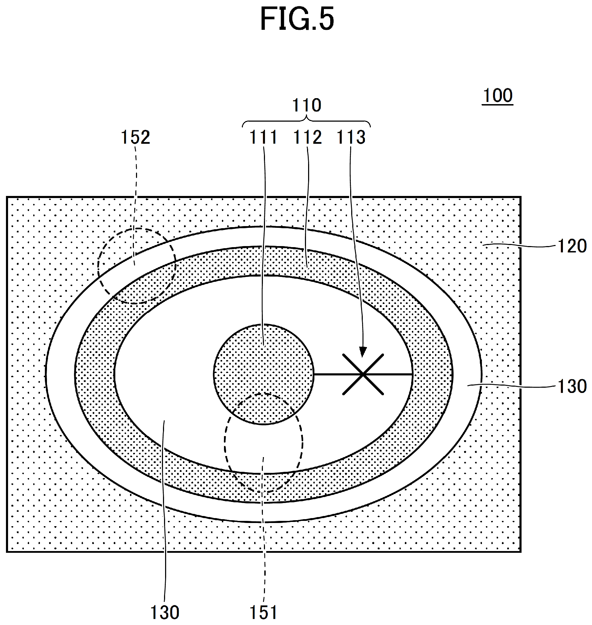

First, a first embodiment will be described. The first embodiment relates to a quantum device. FIG. 5 is a schematic diagram illustrating a quantum device according to the first embodiment.

As illustrated in FIG. 5, a quantum device 100 according to the first embodiment includes a qubit 110, a ground conductor 120, and a substrate 130. The qubit 110 includes an internal conductor 111, an external conductor 112, and a Josephson junction element 113. The internal conductor 111, the external conductor 112, the Josephson junction element 113, and the ground conductor 120 are provided on a main surface of the substrate 130. The external conductor 112 surrounds the internal conductor 111 in a plan view perpendicular to the main surface of the substrate 130. The internal conductor 111 and the external conductor 112 are electrically insulated from each other. The ground conductor 120 is provided outward of the external conductor 112 and surrounds the internal conductor 111 and the external conductor 112 in a plan view perpendicular to the main surface of the substrate 130. The external conductor 112 and the ground conductor 120 are electrically insulated from each other. The Josephson junction element 113 is provided between the internal conductor 111 and the external conductor 112 and is connected between the internal conductor 111 and the external conductor 112. In the present embodiment, an electrical control signal is supplied to the internal conductor 111. The internal conductor 111 is an example of a first conductor, and the external conductor 112 is an example of a second conductor.

The quantum device 100 includes a capacitor 151 including the internal conductor 111 and the external conductor 112, and a capacitor 152 including the external conductor 112 and the ground conductor 120. The capacitance of the capacitor 151 corresponds to the capacitance C4 of the capacitor 4 in FIG. 1, and the capacitance of the capacitor 152 corresponds to the capacitance C6 of the capacitor 6 in FIG. 1. The capacitance of the qubit 110 with respect to ground is 10 fF or more and 30 fF or less. The capacitance of the capacitor 152 may be 10 fF or more and 30 fF or less. The capacitance of the capacitor 152 can be adjusted by, for example, the facing area between the external conductor 112 and the ground conductor 120 and the distance between the external conductor 112 and the ground conductor 120. The ground conductor 120 has ground potential.

In the first embodiment, because the capacitance of the qubit 110 with respect to ground is 10 fF or more and 30 fF or less, a large internal current can be obtained in the qubit 110.

### (Second Embodiment)

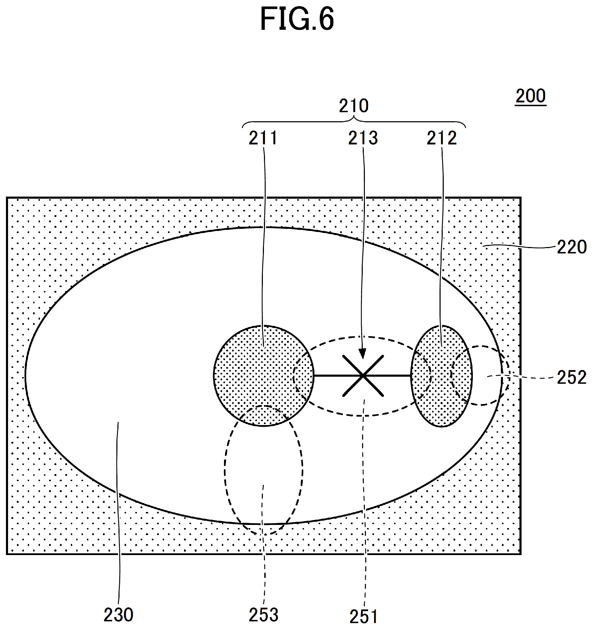

Next, a second embodiment will be described. The second embodiment differs from the first embodiment mainly in a configuration of a qubit. FIG. 6 is a schematic diagram illustrating a quantum device according to the second embodiment.

As illustrated in FIG. 6, a quantum device 200 according to the second embodiment includes a qubit 210, a ground conductor 220, and a substrate 130. The qubit 210 includes a first conductor 211, a second conductor 212, and a Josephson junction element 213. The first conductor 211, the second conductor 212, the Josephson junction element 213, and the ground conductor 220 are provided on a main surface of the substrate 130. The first conductor 211 and the second conductor 212 are arranged side by side in a plan view perpendicular to the main surface of the substrate 130. The ground conductor 220 surrounds the first conductor 211 and the second conductor 212 in a plan view perpendicular to the main surface of the substrate 130. The first conductor 211, the second conductor 212, and the ground conductor 220 are electrically insulated from each other. The Josephson junction element 213 is provided between the first conductor 211 and the second conductor 212 and is connected between the first conductor 211 and the second conductor 212. In the present embodiment, an electrical control signal is supplied to the first conductor 211. The ground conductor 220 has ground potential.

The quantum device 200 includes a capacitor 251 including the first conductor 211 and the second conductor 212, a capacitor 252 including the second conductor 212 and the ground conductor 220, and a capacitor 253 including the first conductor 211 and the ground conductor 220. The capacitance of the capacitor 251 corresponds to the capacitance C4 of the capacitor 4 in FIG. 1, and a combined capacitance of the capacitance of the capacitor 252 and the capacitance of the capacitor 253 corresponds to the capacitance C6 of the capacitor 6 in FIG. 1. The capacitance of the qubit 210 with respect to ground is 10 fF or more and 30 fF or less. The combined capacitance of the capacitance of the capacitor 252 and the capacitance of the capacitor 253 may be 10 fF or more and 30 fF or less. The capacitance of the capacitor 252 can be adjusted by, for example, the facing area between the second conductor 212 and the ground conductor 220 and the distance between the second conductor 212 and the ground conductor 220. The capacitance of the capacitor 253 can be adjusted by, for example, the facing area between the first conductor 211 and the ground conductor 220 and the distance between the first conductor 211 and the ground conductor 220.

In the second embodiment, because the capacitance of the qubit 210 with respect to ground is 10 fF or more and 30 fF or less, a large internal current can be obtained in the qubit 210.

### (Third Embodiment)

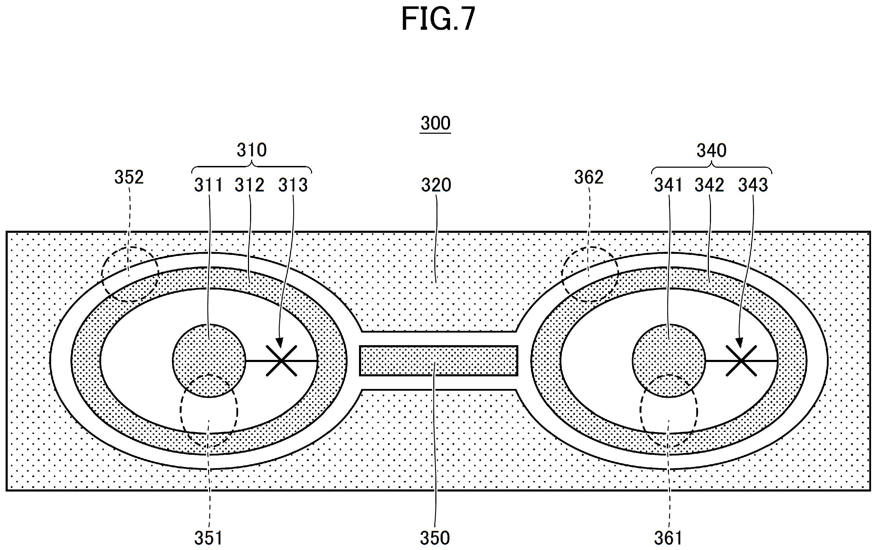

Next, a third embodiment will be described. The third embodiment differs from the first embodiment in that a plurality of qubits are included. FIG. 7 is a schematic diagram illustrating a quantum device according to the third embodiment.

As illustrated in FIG. 7, a quantum device 300 according to the third embodiment includes a qubit 310, a qubit 340, a ground conductor 320, a relay conductor 350, and a substrate 130. The qubit 310 includes an internal conductor 311, an external conductor 312, and a Josephson junction element 313. The qubit 340 includes an internal conductor 341, an external conductor 342, and a Josephson junction element 343. The internal conductor 311, the external conductor 312, and the Josephson junction element 313 have the same configurations as those of the internal conductor 311, the external conductor 312, and the Josephson junction element 313, respectively. The internal conductor 341, the external conductor 342, and the Josephson junction element 343 also have the same configurations as those of the internal conductor 311, the external conductor 312, and the Josephson junction element 313, respectively. The external conductors 312 and 342 are electrically insulated from each other. The ground conductor 320 has ground potential.

The relay conductor 350 is provided between the external conductor 312 and the external conductor 342 on a main surface of the substrate 130, and is electrically insulated from the external conductors 312 and 342. The relay conductor 350 faces each of the external conductors 312 and 342 and is capacitively coupled to each of the external conductors 312 and 342. The external conductors 312 and 342 are capacitively coupled to each other via the relay conductor 350. In a plan view perpendicular to the main surface of the substrate 130, the ground conductor 320 is provided outward of the external conductors 312 and 342 and surrounds the internal conductor 311, the internal conductor 341, the external conductor 312, the external conductor 342, and the relay conductor 350. In the present embodiment, electrical control signals are supplied to the internal conductors 311 and 341. The internal conductors 311 and 341 are examples of first conductors, and the external conductors 312 and 342 are examples of second conductors.

The quantum device 300 includes a capacitor 351 including the internal conductor 311 and the external conductor 312, and a capacitor 352 including the external conductor 312 and the ground conductor 320. The capacitance of the capacitor 351 corresponds to the capacitance C4 of the capacitor 4 in FIG. 1, and the capacitance of the capacitor 352 corresponds to the capacitance C6 of the capacitor 6 in FIG. 1. The quantum device 300 further includes a capacitor 361 including the internal conductor 341 and the external conductor 342, and a capacitor 362 including the external conductor 342 and the ground conductor 320. The capacitance of the capacitor 361 corresponds to the capacitance C4 of the capacitor 4 in FIG. 1, and the capacitance of the capacitor 362 corresponds to the capacitance C6 of the capacitor 6 in FIG. 1. Each of the capacitance of the qubit 310 with respect to ground and the capacitance of the qubit 340 with respect to ground is 10 fF or more and 30 fF or less. Each of the capacitance of the capacitor 352 and the capacitance of the capacitor 362 may be 10 fF or more and 30 fF or less. The capacitance of the capacitor 352 can be adjusted by, for example, the facing area between the external conductor 312 and the ground conductor 320 and the distance between the external conductor 312 and the ground conductor 320. The capacitance of the capacitor 362 can be adjusted by, for example, the facing area between the external conductor 342 and the ground conductor 320 and the distance between the external conductor 342 and the ground conductor 320.

In the third embodiment, because the capacitance of the qubit 310 with respect to ground is 10 fF or more and 30 fF or less, a large internal current can be obtained in the qubit 310. Further, because the capacitance of the qubit 340 with respect to ground is 10 fF or more and 30 fF or less, a large internal current can be obtained in the qubit 340.

Further, because each of the capacitance of the qubit 310 with respect to ground and the capacitance of the qubit 340 with respect to ground is as small as 10 fF or more and 30 fF or less, identifiable capacitive coupling can be obtained between the qubit 310 and the qubit 340 even when a capacitance between the external conductor 312 and the relay conductor 350 and a capacitance between the external conductor 342 and the relay conductor 350 are small. Therefore, even when the qubit 310 or 340 is capacitively coupled to another qubit, crosstalk can be suppressed.

### (Fourth Embodiment)

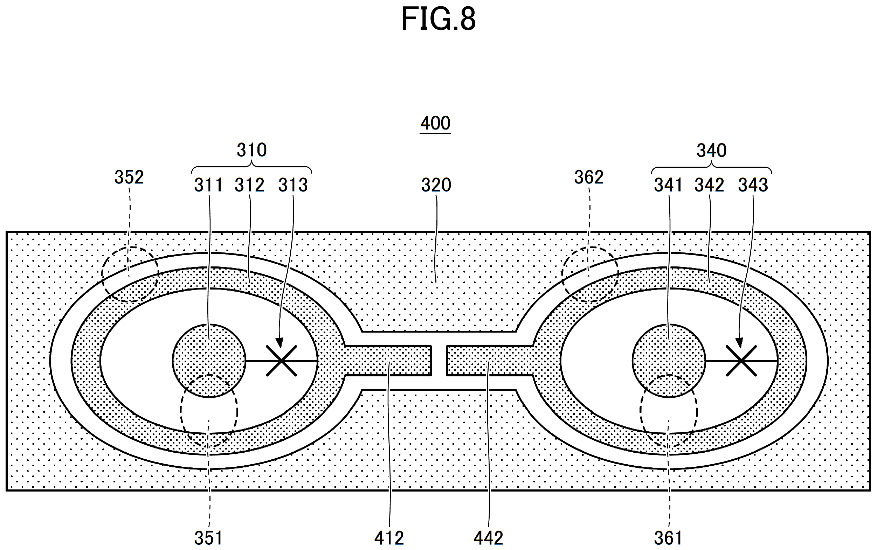

Next, a fourth embodiment will be described. The fourth embodiment differs from the third embodiment mainly in a configuration of capacitive coupling between qubits. FIG. 8 is a schematic diagram illustrating a quantum device according to the fourth embodiment.

As illustrated in FIG. 8, a quantum device 400 according to the fourth embodiment includes a qubit 310, a qubit 340, a ground conductor 320, and a substrate 130. The quantum device 400 does not include a relay conductor 350. An external conductor 312 includes an extension portion 412 extending toward an external conductor 342, and the external conductor 342 includes an extension portion 442 extending toward the external conductor 312. The extension portions 412 and 442 face each other and are capacitively coupled to each other.

Other configurations of the fourth embodiment are the same as those of the third embodiment. According to the fourth embodiment, the same effects as those of the third embodiment can be obtained.

### (Fifth Embodiment)

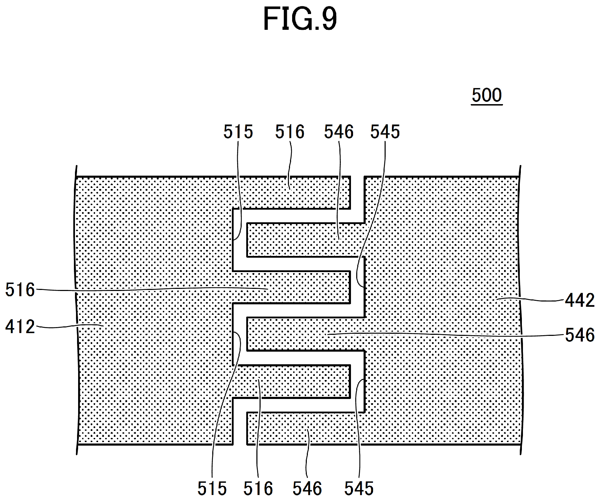

Next, a fifth embodiment will be described. The fifth embodiment differs from the fourth embodiment mainly in a configuration of extension portions of external conductors. FIG. 9 is a schematic diagram illustrating extension portions of a quantum device according to the fifth embodiment.

As illustrated in FIG. 9, in a quantum device 500 according to the fifth embodiment, a plurality of recessed portions 515 and a plurality of projecting portions 516 are alternately formed in a portion of an extension portion 412 facing an extension portion 442, and a plurality of recessed portions 545 and a plurality of projecting portions 546 are alternately formed in a portion of the extension portion 442 facing the extension portion 412. That is, the portion of the extension portion 412 facing the extension portion 442 has a comb-like shape, and the portion of the extension portion 442 facing the extension portion 412 has a comb-like shape. The projecting portions 516 enter the recessed portions 545, and the projecting portions 546 enter the recessed portions 515. The recessed portions 515 are examples of first recessed portions, and the projecting portions 516 are examples of first projecting portions. The recessed portions 545 are examples of second recessed portions, and the projecting portions 546 are examples of second projecting portions.

Other configurations of the fifth embodiment are the same as those of the fourth embodiment. According to the fifth embodiment, the same effects as those of the fourth embodiment can be obtained. Further, in the fifth embodiment, because a large facing area is obtained between the extension portion 412 and the extension portion 442, a large capacitance can be obtained between a qubit 310 and a qubit 340.

### (Sixth Embodiment)

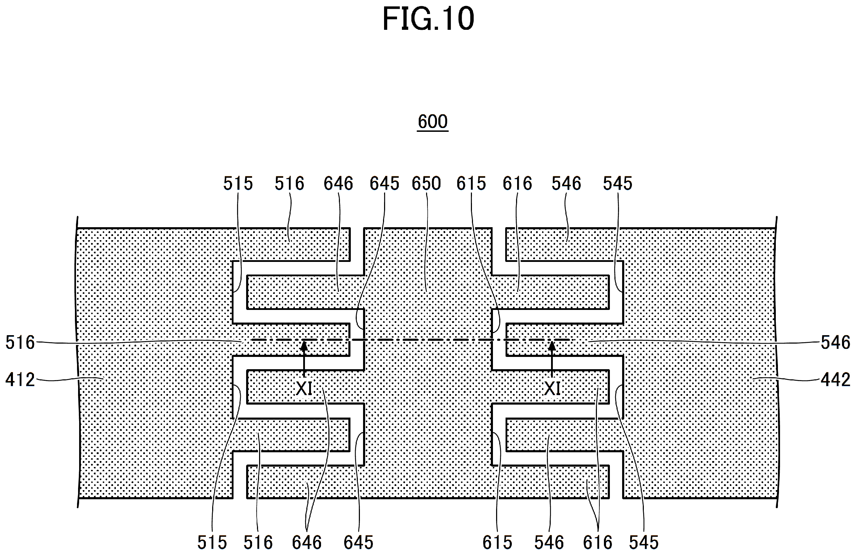

Next, a sixth embodiment will be described. The sixth embodiment differs from the fifth embodiment mainly in a configuration of capacitive coupling between qubits. FIG. 10 is a schematic diagram illustrating extension portions of a quantum device according to the sixth embodiment.

As illustrated in FIG. 10, similar to the fifth embodiment, in a quantum device 600 according to the sixth embodiment, a plurality of recessed portions 515 and a plurality of projecting portions 516 are formed in an extension portion 412, and a plurality of recessed portions 545 and a plurality of projecting portions 546 are alternately formed in an extension portion 442. The quantum device 600 includes a relay conductor 650. A plurality of recessed portions 615 and a plurality of projecting portions 616 are alternately formed in a portion of the relay conductor 650 facing the extension portion 442, and a plurality of recessed portions 645 and a plurality of projecting portions 646 are alternately formed in a portion of the relay conductor 650 facing the extension portion 412. That is, the portion of the relay conductor 650 facing the extension portion 442 has a comb-like shape, and the portion of the relay conductor 650 facing the extension portion 412 has a comb-like shape. The projecting portions 516 enter the recessed portions 645, the projecting portions 646 enter the recessed portions 515, the projecting portions 546 enter the recessed portions 615, and the projecting portions 616 enter the recessed portions 545. The recessed portions 515 are examples of fifth recessed portions, and the projecting portions 516 are examples of fifth projecting portions. The recessed portions 645 are examples of sixth recessed portions, and the projecting portions 646 are examples of sixth projecting portions. The recessed portions 615 are examples of seventh recessed portions, and the projecting portions 616 are examples of seventh projecting portions. The recessed portions 545 are examples of eighth recessed portions, and the projecting portions 546 are examples of eighth projecting portions.

Other configurations of the sixth embodiment are the same as those of the fifth embodiment. The sixth embodiment also provides the same effects as those of the fifth embodiment. According to the sixth embodiment, the same effects as those of the fifth embodiment can be obtained.

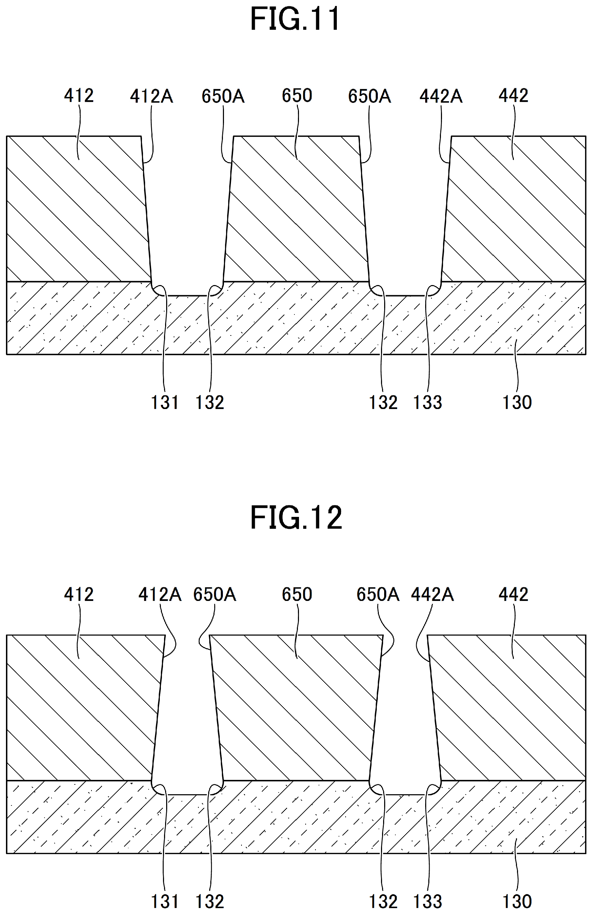

Herein, the cross-sectional shapes of the extension portion 412, the relay conductor 650, and the extension portion 442 will be described as examples. FIGS. 11 and 12 are cross-sectional views illustrating examples of the cross-sectional shapes of the extension portion 412, the relay conductor 650, and the extension portion 442. FIGS. 11 and 12 correspond to cross-sectional views taken along the line XI-XI of FIG. 10.

In the example illustrated in FIG. 11, a main surface of a substrate 130 has a recessed surface 131 continuous with a side surface 412A of the extension portion 412, recessed surfaces 132 continuous with side surfaces 650A of the relay conductor 650, and a recessed surface 133 continuous with a side surface 442A of the extension portion 442. In the example illustrated in FIG. 11, the side surfaces 412A, 442A, and 650A are inclined such that the distance between the side surface 412A and the side surface 650A and the distance between the side surface 442A and the side surface 650A increase, respectively, in a direction away from the substrate 130.

In the example illustrated in FIG. 12 the side surfaces 412A, 442A, and 650A are inclined such that the distance between the side surface 412A and the side surface 650A and the distance between the side surface 442A and the side surface 650A decrease, respectively, in a direction away from the substrate 130.

Note that the cross-sectional shapes of the extension portion 412, the relay conductor 650, and the extension portion 442 are not limited thereto.

### (Seventh Embodiment)

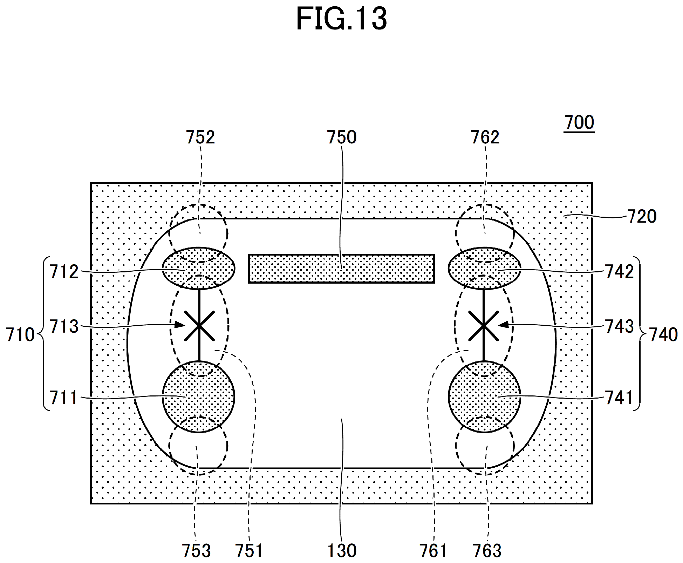

Next, a seventh embodiment will be described. The seventh embodiment differs from the second embodiment mainly in that a plurality of qubits are included. FIG. 13 is a schematic diagram illustrating a quantum device according to the seventh embodiment.

As illustrated in FIG. 13, a quantum device 700 according to the seventh embodiment includes a qubit 710, a qubit 740, a ground conductor 720, a relay conductor 750, and a substrate 130. The qubit 710 includes a first conductor 711, a second conductor 712, and a Josephson junction element 713. The qubit 740 includes a first conductor 741, a second conductor 742, and a Josephson junction element 743. The first conductor 711, the second conductor 712, and the Josephson junction element 713 have the same configurations as those of the first conductor 211, the second conductor 212, and the Josephson junction element 213, respectively. The first conductor 741, the second conductor 742, and the Josephson junction element 743 also have the same configurations as those of the first conductor 211, the second conductor 212, and the Josephson junction element 213, respectively. The first conductor 711, the second conductor 712, the first conductor 741, and the second conductor 742 are electrically insulated from each other. The relay conductor 750 is provided between the second conductor 712 and the second conductor 742 on a main surface of the substrate 130, and is electrically insulated from the second conductors 712 and 742. The relay conductor 750 faces each of the second conductors 712 and 742 and is capacitively coupled to each of the second conductors 712 and 742. The second conductors 712 and 742 are capacitively coupled to each other via the relay conductor 750. In a plan view perpendicular to the main surface of the substrate 130, the ground conductor 720 surrounds the first conductor 711, the second conductor 712, the first conductor 741, the second conductor 742, and the relay conductor 750. In the present embodiment, electrical control signals are supplied to the first conductors 711 and 741. The ground conductor 720 has ground potential.

The quantum device 700 includes a capacitor 751 including the first conductor 711 and the second conductor 712, a capacitor 752 including the second conductor 712 and the ground conductor 720, and a capacitor 753 including the first conductor 711 and the ground conductor 720. The capacitance of the capacitor 751 corresponds to the capacitance C4 of the capacitor 4 in FIG. 1, and a combined capacitance of the capacitance of the capacitor 752 and the capacitance of the capacitor 753 corresponds to the capacitance C6 of the capacitor 6 in FIG. 1. The quantum device 700 further includes a capacitor 761 including the first conductor 741 and the second conductor 742, a capacitor 762 including the second conductor 742 and the ground conductor 720, and a capacitor 763 including the first conductor 741 and the ground conductor 720. The capacitance of the capacitor 761 corresponds to the capacitance C4 of the capacitor 4 in FIG. 1, and a combined capacitance of the capacitance of the capacitor 762 and the capacitance of the capacitor 763 corresponds to the capacitance C6 of the capacitor 6 in FIG. 1. Each of the capacitance of the qubit 710 with respect to ground and the capacitance of the qubit 740 with respect to ground is 10 fF or more and 30 fF or less. The combined capacitance of the capacitance of the capacitor 752 and the capacitance of the capacitor 753 and the combined capacitance of the capacitance of the capacitor 762 and the capacitance of the capacitor 763 may each be 10 fF or more and 30 fF or less. The capacitance of the capacitor 752 can be adjusted by, for example, the facing area between the second conductor 712 and the ground conductor 720 and the distance between the second conductor 712 and the ground conductor 720. The capacitance of the capacitor 753 can be adjusted by, for example, the facing area between the first conductor 711 and the ground conductor 720 and the distance between the first conductor 711 and the ground conductor 720. The capacitance of the capacitor 762 can be adjusted by, for example, the facing area between the second conductor 742 and the ground conductor 720 and the distance between the second conductor 742 and the ground conductor 720. The capacitance of the capacitor 763 can be adjusted by, for example, the facing area between the first conductor 741 and the ground conductor 720 and the distance between the first conductor 741 and the ground conductor 720.

In the seventh embodiment, because the capacitance of the qubit 710 with respect to ground is 10 fF or more and 30 fF or less, a large internal current can be obtained in the qubit 710. Further, because the capacitance of the qubit 740 with respect to ground is 10 fF or more and 30 fF or less, a large internal current can be obtained in the qubit 740.

Further, because the capacitance of the qubit 710 with respect to ground and the capacitance of the qubit 740 with respect to ground are as small as 10 fF or more and 30 fF or less, identifiable capacitive coupling can be obtained between the qubit 710 and the qubit 740 even when a capacitance between the second conductor 712 and the relay conductor 750 and a capacitance between the second conductor 742 and the relay conductor 750 are small. Therefore, even when the qubit 710 or the qubit 740 is capacitively coupled to another qubit, crosstalk can be suppressed.

### (Eighth Embodiment)

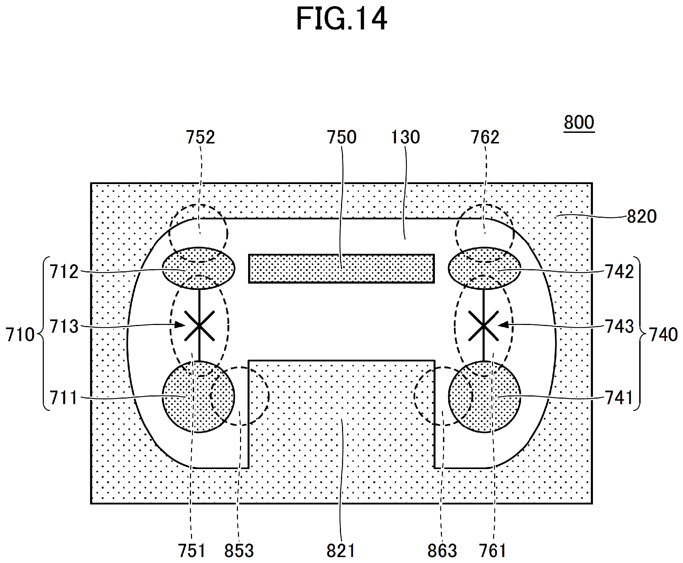

Next, an eighth embodiment will be described. The eighth embodiment differs from the seventh embodiment mainly in a configuration of a ground conductor. FIG. 14 is a schematic diagram illustrating a quantum device according to the eighth embodiment.

As illustrated in FIG. 14, a quantum device 800 according to the eighth embodiment includes a ground conductor 820 instead of the ground conductor 720. The ground conductor 820 includes a proximity portion 821 located between a first conductor 711 and a first conductor 741. The proximity portion 821 faces the first conductors 711 and 741. The ground conductor 820 has ground potential.

Other configurations of the eighth embodiment are the same as those of the seventh embodiment. According to the eighth embodiment, the same effects as those of the seventh embodiment can be obtained. Further, in the seventh embodiment, because the ground conductor 820 includes the proximity portion 821, the capacitance of a capacitor 853 between the ground conductor 820 and the first conductor 711 is larger than the capacitance of a capacitor 752, and the capacitance of a capacitor 863 between the ground conductor 820 and the first conductor 741 is larger than the capacitance of a capacitor 762.

### (Ninth Embodiment)

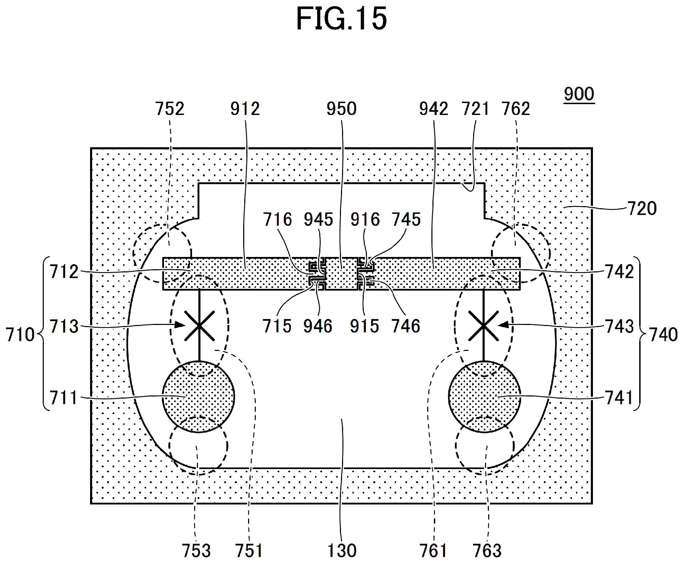

Next, a ninth embodiment will be described. The ninth embodiment differs from the seventh embodiment mainly in a configuration of capacitive coupling between qubits. FIG. 15 is a schematic diagram illustrating a quantum device according to the ninth embodiment.

As illustrated in FIG. 15, in a quantum device 900 according to the ninth embodiment, a second conductor 712 includes an extension portion 912 extending toward a second conductor 742, and the second conductor 742 includes an extension portion 942 extending toward the second conductor 712. The quantum device 900 includes a relay conductor 950. A plurality of recessed portions 715 and a plurality of projecting portions 716 are alternately formed in a portion of the extension portion 912 facing the relay conductor 950, and a plurality of recessed portions 745 and a plurality of projecting portions 746 are alternately formed in a portion of the extension portion 942 facing the relay conductor 950. That is, the portion of the extension portion 912 facing the relay conductor 950 has a comb-like shape, and the portion of the extension portion 942 facing the relay conductor 950 has a comb-like shape. A plurality of recessed portions 915 and a plurality of projecting portions 916 are alternately formed in a portion of the relay conductor 950 facing the extension portion 942, and a plurality of recessed portions 945 and a plurality of projecting portions 946 are alternately formed in a portion of the relay conductor 950 facing the extension portion 912. That is, the portion of the relay conductor 950 facing the extension portion 942 has a comb-like shape, and a portion of the relay conductor 950 facing the extension portion 912 has a comb-like shape. The projecting portions 716 enter the recessed portions 945, the projecting portions 946 enter the recessed portions 715, the projecting portions 746 enter the recessed portions 915, and the projecting portions 916 enter the recessed portions 745. The ground conductor 720 may have a recessed portion 721 recessed so as to be separated from the relay conductor 950.

Other configurations of the ninth embodiment are the same as those of the seventh embodiment. According to the ninth embodiment, the same effects as those of the seventh embodiment can be obtained. Further, in the ninth embodiment, a large facing area is obtained between the extension portion 912 and the relay conductor 950, and a large facing area is obtained between the extension portion 942 and the relay conductor 950. Thus, a large capacitance can be obtained between a qubit 910 and a qubit 940 via the relay conductor 950.

### (Tenth Embodiment)

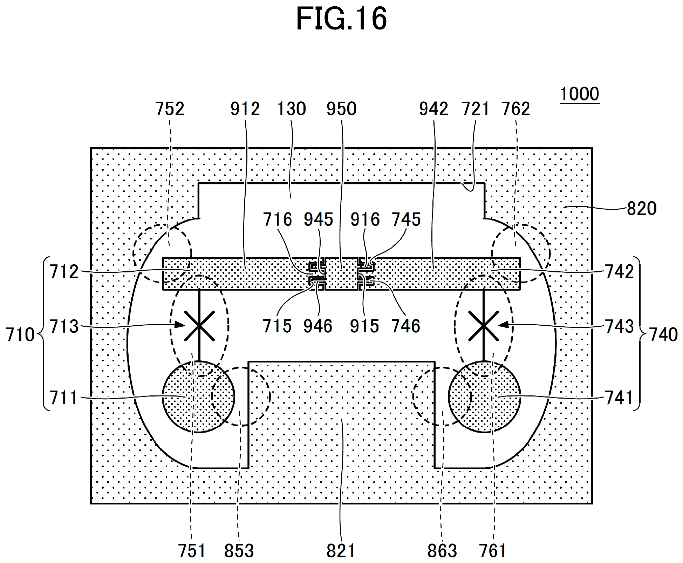

Next, a tenth embodiment will be described. The tenth embodiment differs from the ninth embodiment mainly in a configuration of a ground conductor. FIG. 16 is a schematic diagram illustrating a quantum device according to the tenth embodiment.

As illustrated in FIG. 16, a quantum device 1000 according to the tenth embodiment includes a ground conductor 820 instead of the ground conductor 720. The ground conductor 820 includes a proximity portion 821 located between a first conductor 711 and a first conductor 741. The proximity portion 821 faces the first conductors 711 and 741.

Other configurations of the tenth embodiment are the same as those of the ninth embodiment. According to the tenth embodiment, the same effects as those of the eighth embodiment and the ninth embodiment can be obtained.

### (Eleventh Embodiment)

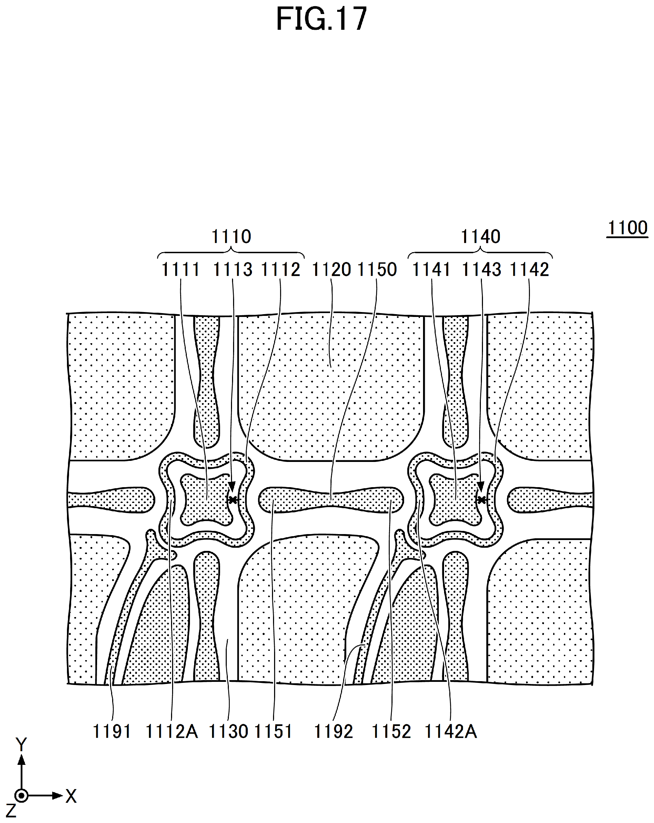

Next, an eleventh embodiment will be described. The eleventh embodiment relates to a quantum device. FIG. 17 is a schematic diagram illustrating the quantum device according to the eleventh embodiment. In the following description, an XYZ orthogonal coordinate system is used. When viewed from an arbitrary point, the +Z side may be referred to as an upper side, a top side, or above, and the -Z side may be referred to as a lower side, a bottom side, or below. However, the coordinate system is defined for the purpose of description and is not intended to limit the orientation of the quantum device.

As illustrated in FIG. 17, a quantum device 1100 according to the eleventh embodiment includes a qubit 1110, a qubit 1140, a ground conductor 1120, a relay conductor 1150, a read conductor 1191, a read conductor 1192, and a substrate 1130. The qubit 1110 includes an internal conductor 1111, an external conductor 1112, and a Josephson junction element 1113. The qubit 1140 includes an internal conductor 1141, an external conductor 1142, and a Josephson junction element 1143. The internal conductor 1111, the internal conductor 1141, the external conductor 1112, the external conductor 1142, the Josephson junction element 1113, the Josephson junction element 1143, the relay conductor 1150, the read conductor 1191, the read conductor 1192, and the ground conductor 1120 are provided on a main surface of the substrate 1130. In a plan view perpendicular to the main surface of the substrate 1130, the external conductor 1112 surrounds the internal conductor 1111, and the external conductor 1142 surrounds the internal conductor 1141. The internal conductor 1111 and the external conductor 1112 are electrically insulated from each other, and the internal conductor 1141 and the external conductor 1142 are electrically insulated from each other. In a plan view, the internal conductors 1111 and 1141 have a shape recessed along the X-axis, recessed along the Y-axis, and protruding in four directions inclined by 45 degrees from the X-axis and Y-axis. In a plan view, the external conductors 1112 and 1142 have a shape conforming to the outer edges of the internal conductors 1111 and 1141, that is, have a shape recessed along the X-axis, recessed along the Y-axis, and protruding in four directions inclined by 45 degrees from the X-axis and Y-axis. The internal conductors 1111 and 1141 are examples of the first conductors, and the external conductors 1112 and 1142 are examples of the second conductors. The ground conductor 1120 has ground potential.

The relay conductor 1150 is provided between the qubit 1110 and the qubit 1140. The relay conductor 1150 has a projecting portion 1151 protruding toward the external conductor 1112, and a projecting portion 1152 protruding toward the external conductor 1142. The external conductor 1112 of the qubit 1110 includes a recessed portion 1112A recessed so as to be separated from the projecting portion 1151. The external conductor 1142 of the qubit 1140 includes a recessed portion 1142A recessed so as to be separated from the projecting portion 1152. The relay conductor 1150 is capacitively coupled to the external conductors 1112 and 1142. The external conductors 1112 and 1142 are capacitively coupled to each other via the relay conductor 1150. The projecting portion 1151 is an example of a third projecting portion, and the recessed portion 1112A is an example of a third recessed portion. The projecting portion 1152 is an example of a fourth projecting portion, and the recessed portion 1142A is an example of a fourth recessed portion.

In the present embodiment, electrical control signals are supplied to the internal conductors 1111 and 1141. The read conductor 1191 is capacitively coupled to the external conductor 1112, and the read conductor 1192 is capacitively coupled to the external conductor 1142. The state of the qubit 1110 is read out to the outside via the read conductor 1191, and the state of the qubit 1140 is read out to the outside via the read conductor 1192.

The ground conductor 1120 surrounds the qubit 1110, the qubit 1140, the relay conductor 1150, the read conductor 1191, and the read conductor 1192. The quantum device 1100 may include another qubit capacitively coupled to the qubit 1110, may include another qubit capacitively coupled to the qubit 1140, and may include a relay conductor capacitively coupling these qubits. In this case, these qubits and the relay conductor are also surrounded by the ground conductor 1120.

Each of the capacitance of the qubit 1110 with respect to ground and the capacitance of the qubit 1140 with respect to ground is 10 fF or more and 30 fF or less. Each of the capacitance of a capacitor including the external conductor 1112 and the ground conductor 1120 and the capacitance of a capacitor including the external conductor 1142 and the ground conductor 1120 may be 10 fF or more and 30 fF.

According to the eleventh embodiment, a large internal current can be obtained in each of the qubits 1110 and 1140. Further, even when the qubit 1110 or 1140 is capacitively coupled to another qubit, crosstalk can be suppressed.

### (Twelfth Embodiment)

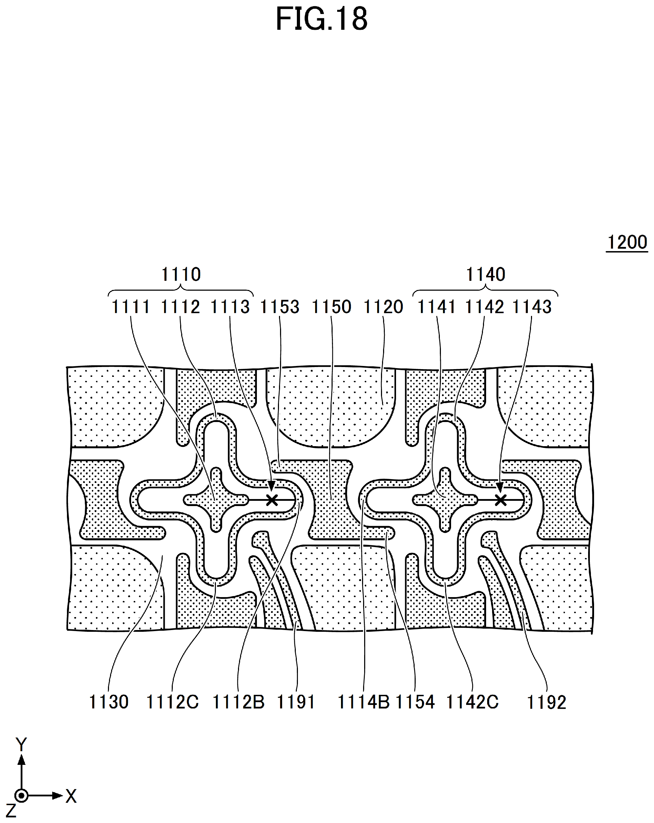

Next, a twelfth embodiment will be described. The twelfth embodiment differs from the eleventh embodiment mainly in a configuration of capacitive coupling between qubits. FIG. 18 is a schematic diagram illustrating a quantum device according to the twelfth embodiment.

As illustrated in FIG. 18, in a quantum device 1200 according to the twelfth embodiment, internal conductors 1111 and 1141 have a shape protruding along the X-axis, protruding along the Y-axis, and recessed in four directions inclined by 45 degrees from the X-axis and Y-axis in a plan view. External conductors 1112 and 1142 have a shape conforming to the outer edges of the internal conductors 1111 and 1141 in a plan view. That is, the external conductor 1112 includes two projecting portions 1112B protruding along the X-axis and two projecting portions 1112C protruding along the Y-axis in a plan view, and the external conductor 1142 includes two projecting portions 1142B protruding along the X-axis and two projecting portions 1142C protruding along the Y-axis in a plan view.

A relay conductor 1150 includes a projecting portion 1153 and a projecting portion 1154. The projecting portion 1153 is located on the + Y side of the +X-side projecting portion 1112B and is capacitively coupled to the +X-side projecting portion 1112B, and the projecting portion 1154 is located on the -Y side of the -X-side projecting portion 1142B and is capacitively coupled to the -X-side projecting portion 1142B.

Other configurations of the twelfth embodiment are the same as those of the eleventh embodiment. According to the twelfth embodiment, the same effects as those of the eleventh embodiment can be obtained.

### (Thirteenth Embodiment)

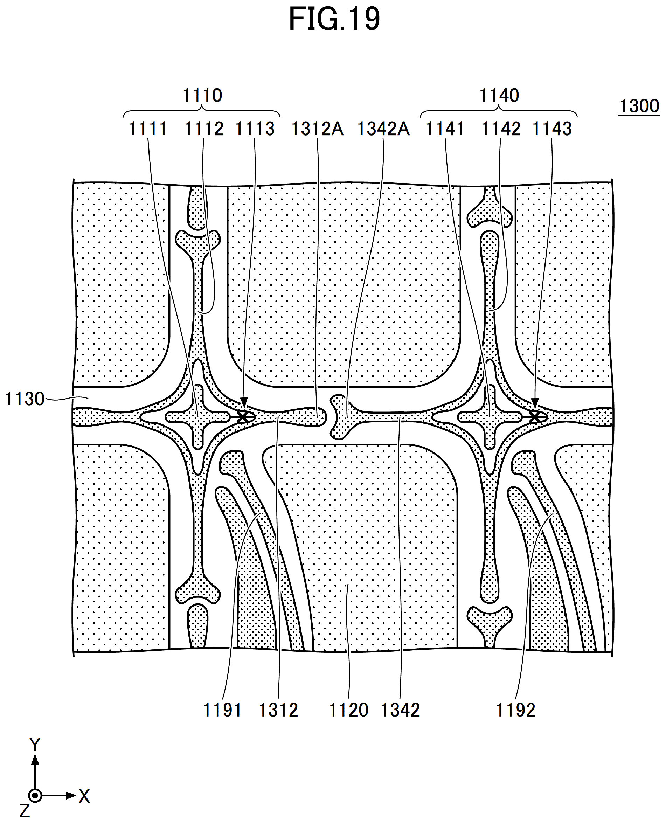

Next, a thirteenth embodiment will be described. The thirteenth embodiment differs from the twelfth embodiment mainly in a configuration of capacitive coupling between qubits. FIG. 19 is a schematic diagram illustrating a quantum device according to the thirteenth embodiment.

As illustrated in FIG. 19, a quantum device 1300 according to the thirteenth embodiment does not include a relay conductor 1150. An external conductor 1112 includes an extension portion 1312 extending toward an external conductor 1142. The external conductor 1142 includes an extension portion 1342 extending toward the external conductor 1112. The extension portion 1312 includes a projecting portion 1312A protruding toward the external conductor 1142. The extension portion 1342 includes a recessed portion 1342A recessed so as to be separated from the external conductor 1112. The extension portions 1312 and 1342 face each other and are capacitively coupled to each other.

Other configurations of the thirteenth embodiment are the same as those of the twelfth embodiment. According to the thirteenth embodiment, the same effects as those of the twelfth embodiment can be obtained.

An example of a method of measuring the capacitance of a qubit with respect to the ground potential according to the present disclosure will be described. In one example, a probe of a capacitance meter is applied to an external conductor and a ground conductor, and a high-frequency signal of 0.2 GHz to 30 GHz is input by a vector network analyzer. Then, S-parameters are measured from an admittance chart. Then, a curve obtained by measuring the S-parameters are fitted to an admittance equation of the system. In this manner, the capacitance of the qubit with respect to the ground potential can be measured.

In another example, the capacitance of a qubit with respect to the ground potential may be calculated from the layout of a first conductor, a second conductor, and a ground conductor. The method of measuring the capacitance of a qubit with respect to the ground potential is not limited to these methods.

The quantum devices according to the present disclosure can be used in, for example, quantum computing.

Although preferred embodiments and the like have been described in detail above, the present disclosure is not limited to the above-described embodiments and the like, and various modifications and substitutions can be made to the above-described embodiments and the like without departing from the scope of the claims.

### DESCRIPTION OF THE REFERENCE NUMERALS

100, 200, 300, 400, 500, 600, 700, 800, 900, 1000, 1100, 1200, 1300: quantum device
110, 210, 310, 340, 710, 740, 910, 940, 1110, 1140: qubit
111, 311, 341, 1111, 1141: internal conductor
112, 312, 342, 1112, 1142: external conductor
113, 213, 313, 343, 713, 743, 1113, 1143: Josephson junction element
120, 220, 320, 720, 820, 1120: ground conductor
130, 1130: substrate
131, 132, 133: recessed surface
151, 152, 251, 252, 253, 351, 352, 361, 362, 751, 752, 753, 761, 762, 763, 853, 863: capacitor
211, 711, 741: first conductor
212, 712, 742: second conductor
350, 650, 750, 950, 1150: relay conductor
412A, 442A, 650A: side surface
515, 545, 615, 645, 715, 745, 915, 945, 1112A, 1142A, 1342A: recessed portion
516, 546, 616, 646, 716, 746, 916, 946, 1112B, 1112C, 1142B, 1142C, 1151, 1152, 1153, 1154, 1312A: projecting portion

## Claims

1. A quantum device comprising:
one or more qubits, wherein
each of the one or more qubits includes
a first conductor,
a second conductor, and
a Josephson junction element connected between the first conductor and the second conductor, and
a capacitance of each of the one or more qubits with respect to ground potential is 10 fF or more and 30 fF or less.

2. The quantum device according to claim 1, wherein
the second conductor surrounds the first conductor in a plan view, and
a capacitance of the second conductor with respect to the ground potential is 10 fF or more and 30 fF or less.

3. The quantum device according to claim 2, further comprising:
a ground conductor provided outward of the second conductor in the plan view and having the ground potential.

4. The quantum device according to claim 1, wherein the capacitance of each of the one or more qubits with respect to the ground potential is a combined capacitance of a capacitance of the first conductor with respect to the ground potential and a capacitance of the second conductor with respect to the ground potential.

5. The quantum device according to any one of claims 1 to 4, wherein
the one or more qubits include a first qubit and a second qubit, and
a second conductor of the first qubit and a second conductor of the second qubit are capacitively coupled to each other.

6. The quantum device according to claim 5, wherein the second conductor of the first qubit and the second conductor of the second qubit face each other.

7. The quantum device according to claim 6, wherein
the second conductor of the first qubit includes a projecting portion protruding toward the second conductor of the second qubit in a plan view, and
the second conductor of the second qubit includes a recessed portion recessed so as to be separated from the second conductor of the first qubit in the plan view.

8. The quantum device according to claim 6, wherein
a plurality of first recessed portions and a plurality of first projecting portions are alternately formed in a portion of the second conductor of the first qubit facing the second conductor of the second qubit in a plan view,
a plurality of second recessed portions and a plurality of second projecting portions are alternately formed in a portion of the second conductor of the second qubit facing the second conductor of the first qubit in the plan view, and
the plurality of first projecting portions enter the plurality of second recessed portions, and the plurality of second projecting portions enter the plurality of first recessed portions in the plan view.

9. The quantum device according to claim 5, further comprising:
a relay conductor facing the second conductor of the first qubit and facing the second conductor of the second qubit.

10. The quantum device according to claim 9, wherein
one of the second conductor of the first qubit or the relay conductor includes a third projecting portion protruding toward the other of the second conductor of the first qubit or the relay conductor in a plan view,
the other of the second conductor of the first qubit or the relay conductor includes a third recessed portion recessed so as to be separated from the one of the second conductor of the first qubit or the relay conductor in the plan view,
one of the second conductor of the second qubit or the relay conductor includes a fourth projecting portion protruding toward the other of the second conductor of the second qubit or the relay conductor in the plan view, and
the other of the second conductor of the second qubit or the relay conductor includes a fourth recessed portion recessed so as to be separated from the one of the second conductor of the second qubit or the relay conductor in the plan view.

11. The quantum device according to claim 9, wherein
a plurality of fifth recessed portions and a plurality of fifth projecting portions are alternately formed in a portion of the second conductor of the first qubit facing the relay conductor in a plan view,
a plurality of sixth recessed portions and a plurality of sixth projecting portions are alternately formed in a portion of the relay conductor facing the second conductor of the first qubit in the plan view,
a plurality of seventh recessed portions and a plurality of seventh projecting portions are alternately formed in a portion of the relay conductor facing the second conductor of the second qubit in the plan view,
a plurality of eighth recessed portions and a plurality of eighth projecting portions are alternately formed in a portion of the second conductor of the second qubit facing the relay conductor in the plan view, and
the plurality of fifth projecting portions enter the plurality of sixth recessed portions, the plurality of sixth projecting portions enter the plurality of fifth recessed portions, the plurality of seventh projecting portions enter the plurality of eighth recessed portions, and the plurality of eighth projecting portions enter the plurality of seventh recessed portions in the plan view.

12. The quantum device according to claim 11, wherein
the second conductor of the first qubit, the second conductor of the second qubit, and the relay conductor are formed on a main surface of a substrate, and
the main surface has a recessed surface continuous with a side surface of the second conductor of the first qubit, a recessed surface continuous with a side surface of the second conductor of the second qubit, and recessed surfaces continuous with respective side surfaces of the relay conductor.

13. The quantum device according to claim 11, wherein
the second conductor of the first qubit, the second conductor of the second qubit, and the relay conductor are formed on a main surface of a substrate,
a side surface of the second conductor of the first qubit facing the relay conductor and a side surface of the relay conductor facing the second conductor of the first qubit are inclined such that a distance between the side surface of the second conductor of the first qubit facing the relay conductor and the side surface of the relay conductor facing the second conductor of the first qubit increases in a direction away from the substrate, and
a side surface of the second conductor of the second qubit facing the relay conductor and a side surface of the relay conductor facing the second conductor of the second qubit are inclined such that a distance between the side surface of the second conductor of the second qubit facing the relay conductor and the side surface of the relay conductor facing the second conductor of the second qubit increases in the direction away from the substrate.
